# EUROPEAN PATENT APPLICATION

(11) **EP 2 378 660 A2**
(43) Date of publication of application: **19.10.2011**
(21) Application number: 11161337.8
(22) Date of filing: 06.04.2011
(51) Int. Cl.: H03F 3/387

(54) **A Signal Processing Circuit**

(30) Priority: 14.04.2010 GB 1006212
(71) Applicant: Rolls-Royce Goodrich Engine Control Systems Ltd., Derby DE24 8BJ (GB)
(72) Inventor: Rice, Peter, Birmingham, West Midlands B14 6QP (GB)
(74) Representative: Beck, Simon Antony

(57) **Abstract**

A signal processing circuit comprising a chopper amplifier (30) in combination with a circuit or device (55) having an acquisition period, and wherein a clock (Chopper Clock Signal) controlling the chopper amplifier (30) is controlled such that a predetermined or known number of clock transitions occur during the acquisition period.

## Description

### FIELD OF THE INVENTION

The present invention relates to a signal processing circuit including a chopper amplifier.

### BACKGROUND OF THE INVENTION

There are times when it is desirable to amplify, potentially with very high gain, a substantially direct current (DC) signal. The signal may be single ended or may be a differential signal which may be in the presence of a further signal, such as a common mode signal which may also be a DC signal, but which could also be an alternating current (AC) signal. The operational amplifier represents a suitable amplifier configuration for amplifying such a signal. Generally, as is known to the person skilled in the art, an operational amplifier has differential inputs, referred to as a non-inverting input and an inverting input, respectively, and the amplifier forms an output which is a large multiple of the voltage difference occurring at its inputs. The amplifier is often included within a feedback loop such that the gain of the amplifier is well determined and can be controlled to be a specific value of gain, and/or have a specific frequency response.

Although integrated circuit technology can provide operational amplifiers where the parameters of input devices within a front end of the amplifier, which is typically a long-tail pair, are well matched such input devices often suffer from an input offset voltage or current depending on whether the amplifier is a voltage mode or current mode amplifier, and this offset can result in an unwanted signal occurring at the output of the amplifier. Furthermore, if the amplifier forms part of an integrator, or the output of the amplifier is provided to an integrator then the offset can be subjected to both amplification and integration and as a result the output of the amplifier or the integrator may no longer be representative of the signals applied to the inputs of the amplifier. Offsets are particularly troublesome in the context of high gain DC amplifiers.

One approach to dealing with offsets is to use a chopper amplifier. The chopper amplifier includes switches in its signal path to break the input signal up so as to form an AC signal. The AC signal at the output of the amplifier may then, for example, be chopped in a similar manner so as to output an apparently DC signal. As a consequence the amplifier need no longer be DC coupled throughout the signal path.

US 7,292,095 discloses an amplifier in which a first stage of the amplifier is associated with an input chopping circuit for swapping the signal connections to the inverting and non-inverting terminals of the amplifier, and an output chopper for switching a dual ended output of the amplifier between an inverted and a non-inverted configuration. The output of the first stage amplifier is provided to an input of a second stage amplifier via a switched capacitor notch filter. The notch filter has a notch at the chopping frequency. The notch filter includes transfer capacitors (C5 and C6) which act to integrate and transfer the signal from the input side of the notch filter to the output side.

US 7,535,295 discloses a chopper stabilised amplifier, in the context of a current mode instrumentation amplifier. A primary signal path is not chopped. Input voltages and feedback voltages are converted by transconductance amplifiers gm3 and gm4 whose outputs are summed (see Figure 3 of US 7,535,295). However a second signal path is provided via input chopping circuits to amplifiers gm7 and gm8, whose outputs are summed and then provided to a further chopper. The chopper amplifiers output is integrated by gm6 which integrates a current until V_{*f*b} = Vᵢₙ, thereby removing the offsets of gm3 and gm4. However the output of gm6 provides both a DC component that eliminates the offset, and a triangular wave which produces ripple at the clock frequency of the chopper circuit. US 7,535,295 introduces a sample and hold circuit at the output of gm6 to reduce the ripple. It also discloses adding an auto-zero phase by storing an offset voltage on auto-zero capacitors in the input signal paths of gm7 and gm8. This does require the introduction of an auto-zero phase where the previous output of the amplifiers are stored by the sample and hold circuit.

US 7,209,000 discloses a combination of chopper amplifiers with multi-path nested miller compensation so as to avoid unwanted artefacts in the frequency response of the amplifier.

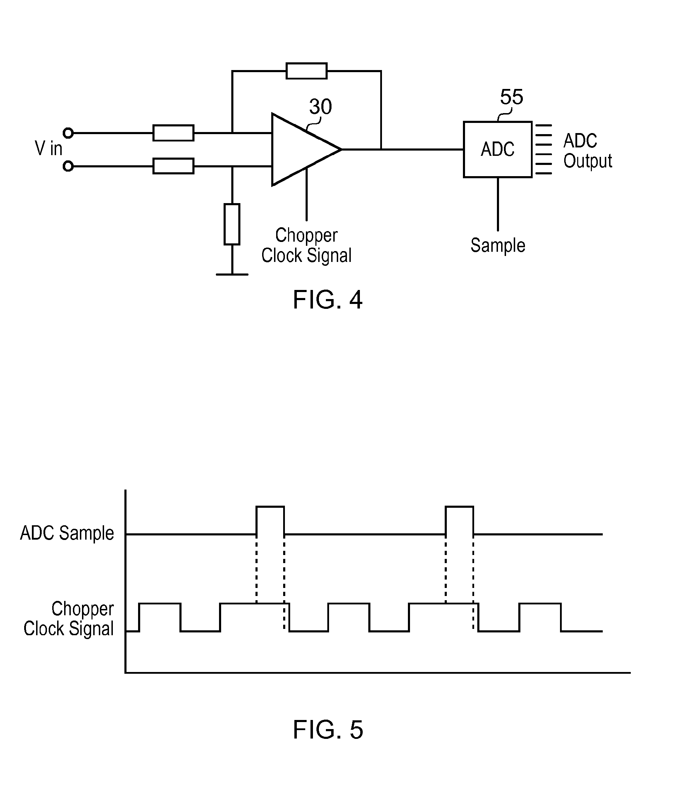

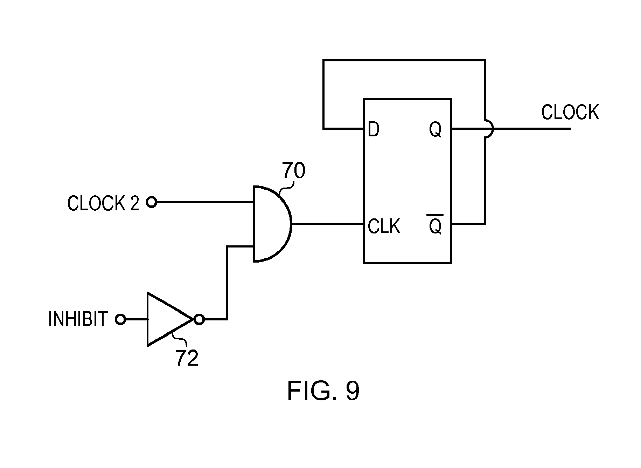

US 7,132,883 discloses a current mode instrumentation amplifier with chopper stabilisation. This specification notes that the use of the chopper circuit can result in ripple at the chopping frequency, and that to reduce this a low pass filter is placed at the output of the amplifier. It also notes that operating the chopping circuit may result in non-optimal performance due to an imperfect 50% duty cycle of the chopper and charge injection. It proposes a basic circuit in Figure 4 which is identical to that of Figure 9 of US 7,209,000. However, the configuration is then improved by the introduction of auto-zero circuits (Figure 5) for the chopper stabilising amplifiers g7 and g8 by the provision of a multiplexer and an integrator which integrates the summed output of g7 and g8 over a chopping cycle to deduce a combined offset value which is fed back by g9. However g9 itself has a offset so a further chopper stabilisation loop is built around g9 to compensate for its offset. Similar input offset compensation is provided for g6.

US 7,170,338 discloses an operational amplifier, primarily for audio signal reproduction. However, the chopping nature of the amplifier gives rise to a gain reduction due to the charge required to charge and discharge parasitic capacitors at output nodes of the amplifier. This problem is lessened by providing a folded cascode output stage.

The artefact reduction, or ripple reduction schemes, described in the prior art come with varying levels of hardware complexity. However it remains inherent that operating a chopping circuit always introduces a perturbation into the signal, if only because the chopping circuit is not made of ideal components and transistor switch on times and switch off times must be accounted for to avoid short circuit paths, and the switching times themselves are unlikely to be the same for "on" to "off" and "off" to "on" for any given transistor.

### SUMMARY OF THE INVENTION

According to a first aspect of the present invention there is provided a signal processing circuit comprising a chopper amplifier in combination with a circuit or device having an acquisition period, and wherein a clock controlling the chopper amplifier is modified or suspended such that a predetermined or known number of clock transitions occur during the acquisition period.

It is thus possible to provide an improved signal processing circuit in which the artefacts resulting from operation of the chopper amplifier can be compensated for or in a particularly preferred embodiment avoided.

Preferably the output of the chopper amplifier is provided to an analog to digital converter. The analog to digital converter advantageously has a sample and hold circuit or a track and hold circuit. These circuits, which are often identical and are only distinguished from one another by the way in which they operate, allow a sampling capacitor of the analog to digital converter to be connected to the output of the amplifier so as to be charged up to the voltage of the output of the amplifier or some other intermediate circuit, such as an integrator. When it is desired to commence analog to digital conversion a sample signal may be asserted so as to initiate connection of the capacitor array to the amplifier or integrator. Once the sample signal is de-asserted then the connection between the sampling capacitor and the circuit driving it is broken, and then the analog to digital converter starts forming a digital representation of the voltage stored on the sampling capacitor. In modem analog to digital converters the sampling capacitor may form part of a switched capacitor array within the analog to digital converter.

In preferred embodiments of the invention the clock for the chopper amplifier is inhibited from making a transition during an "inhibition period" which may be coincident with an acquisition window of the analog to digital converter, which can be regarded as the period either spanning the sample period, or a period just in advance of the analog to digital converter's mode transition from "acquire" to "convert".

Advantageously the signal processing circuit further includes an integrator for integrating an output of the chopper amplifier over an integration period. Once the integration period is complete the output of the integrator is passed to the analog to digital converter for conversion. The use of an integrator has the advantage of significantly reducing an unwanted noise power passed to the analog to digital converter. It also enables the wanted substantially DC signal to be separated from AC signals occurring at the input to the chopping amplifier by virtue of the low pass filter action of the integrator.

According to a second aspect of the present invention there is provided a method of processing a signal, the method comprising amplifying the signal using a chopper amplifier, and acquiring an output from the chopper amplifier during an acquisition period, wherein a clock signal controlling the chopper amplifier is modified or suspended so as to make a predetermined number of transitions during the acquisition period.

### BRIEF DESCRIPTION OF THE DRAWINGS

The present invention will further be described, by way of non-limiting example, with reference to the accompanying Figures, in which:
Figure 1 schematically illustrates a simple configuration of a known chopper amplifier;
Figure 2 schematically illustrates an amplifier in a feedback stabilised voltage mode configuration;
Figures 3a to 3c illustrate the operation of the amplifier in Figures 1 and 2 and the currents of artefacts in the amplifier output corresponding to transitions of the control clock;
Figure 4 schematically illustrates a chopper amplifier in combination with an analog to digital converter, and controlled so as to constitute a first embodiment of the present invention;
Figure 5 is a timing diagram for operation of the amplifier shown in Figure 4;
Figure 6 is a schematic diagram of a combination of a chopper amplifier and an integrator and analog to digital converter controlled so as to constitute an embodiment of the present invention;
Figure 7 represents a first timing diagram for operation of the circuit shown in Figure 6.
Figure 8 represents a second timing diagram for an alternate mode of operation for the circuit shown in Figure 6;
Figure 9 is a configuration of a clock inhibition circuit suitable for use with the embodiments shown in Figures 4 and 6.

### DESCRIPTION OF PREFERRED EMBODIMENTS OF THE PRESENT INVENTION

As mentioned herein chopper amplifiers can be used to obtain good DC gain and offset performance.

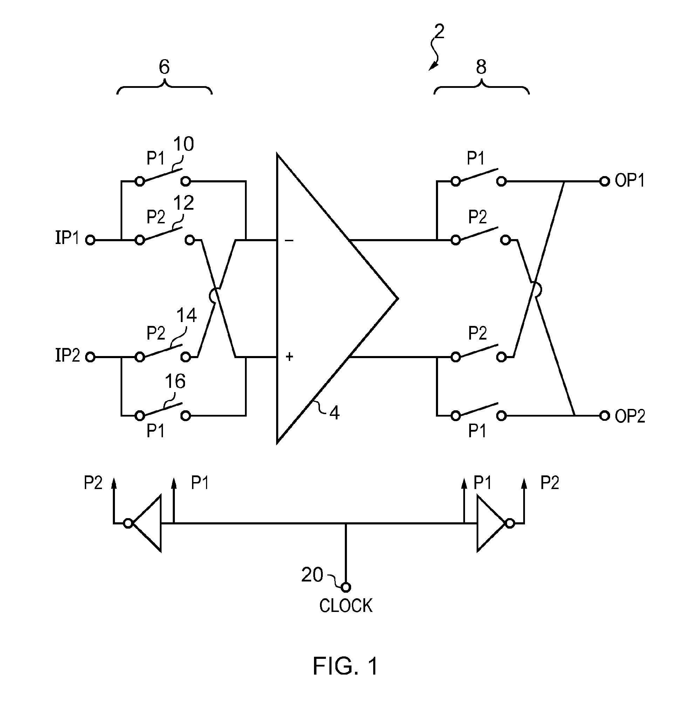

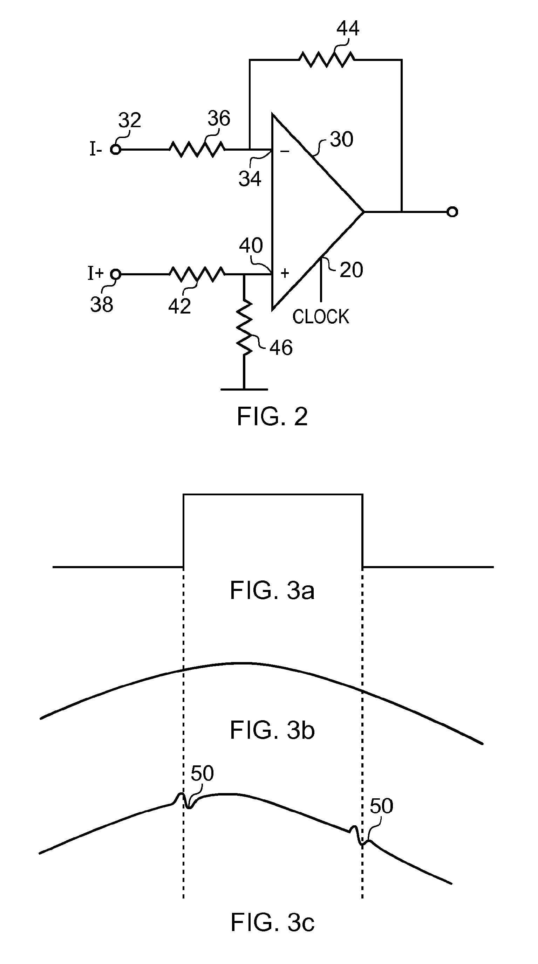

Chopper amplifiers may chop either the entirety of the signal path or, as disclosed in some of the prior art referenced hereinbefore the chopper amplifier may split the input signal to two or more paths, with one of the paths being amplified in a conventional manner and the other path being used to perform offset compensation by use of the chopper circuit. In the context of the present invention "chopper amplifier" can refer to any of the configurations described above or indeed to multi-channel amplifiers operating in a chopping mode. However, for the sake of completeness the operation of a simple chopper amplifier will be described. Such an arrangement corresponds to that shown in US 7,292,095. The chopper amplifier shown in Figure 1, and generally designated 2, comprises an operational amplifier 4 disposed between an input chopping circuit 6 and an output chopping circuit 8. The amplifier 4 is a dual ended device, although it may be only one amplifier block inside a more complex amplifier circuit, and that circuit may include dual ended to single ended conversion amplifiers such that the amplifier as a whole looks like a conventional single ended operational amplifier suitable for use in the circuit shown in Figure 2. However the invention is not limited to such a configuration as dual ended operational amplifiers having a differential output may also be included within an amplifier circuit and may interface with dual ended analog to digital converters having inverting and non-inverting inputs.

The chopping circuits are similar, so only the first chopping circuit 6 will be described in detail. The circuit comprises four switches 10, 12, 14 and 16 which, in reality, are implemented as transistor switches. The first switch 10 extends between the first input IP1 and the inverting input of the amplifier 4. The second switch 12 extends between the first input IP1 and the non-inverting input of the amplifier 4.

The third switch 14 extends between the second input IP2 and the inverting input of the amplifier 4, and the fourth switch 16 extends between the second input and the non-inverting input of the amplifier 4. The switches are driven in anti-phase by signals P1 and P2 such that if P1 is asserted then P2 is not. Thus when P1 is asserted switches 10 and 16 are closed and switches 12 and 14 are open. Consequently input IP1 is connected to the inverting input of the amplifier and the input IP2 is connected to the non-inverting input of the amplifier 4. If signal P1 is de-asserted and signal P2 asserted then it can be seen that in this configuration input IP1 is swapped so as to be connected to the non-inverting input of the amplifier 4, whereas input IP2 is connected to the inverting input. The switches are driven by a clock signal provided at a clock input 20 with, in this example, the clock signal being used to provide the signal P1 and an inverted version of the clock being used to derive the signal P2.

A similar chopping circuit is provided at the output of the amplifier and driven in phase with the first chopping circuit 6. Thus the swapping of connections at the input of the amplifier occurs in synchronism with swapping of connections at the output of the amplifier. Thus if a DC signal is provided to the input terminals IP1 and IP2 then the amplifier thinks its receiving an AC signal having a frequency at the clock frequency and it amplifies this, but the output of the amplifier at terminals OP1 and OP2 still appears as a DC signal. Consequently the amplifier 4 can be designed to operate as an AC amplifier, and this makes it easier to control offsets within the amplifier as the entire amplifier no longer needs to be DC coupled. However, as noted before it is also possible to provide chopper stabilisation to a DC coupled amplifier and, in the context of the present invention such an amplifier is also to be considered as a chopper amplifier.

More complex chopper amplifier designs also include auto-zeroing and again such enhancements are still considered to be a chopper amplifier as used within the context of the present invention.

Figure 2 schematically illustrates a feedback stabilised chopper amplifier. Thus the amplifier 30 may include the circuit shown in Figure 1 and looks like a conventional operational amplifier apart from the fact that it includes the clock input 20. An inverting input terminal 32 is connected to an inverting input 34 of the amplifier via a resistor 36. Similarly a non-inverting input terminal 38 is connected to the non-inverting input 40 of the amplifier via a resistor 42. The gain of the amplifier is set, in this configuration, by the relative sizes of a further resistor 44 extending between an output of the amplifier 30 and the inverting input 34, and the resistor 36. An additional resistor 46 extends between the non-inverting input 40 and the ground so as to balance the amplifier such that the input impedance as viewed from the terminals 32 and 38 remains the same for each terminal.

In use the amplifier is driven with the clock signal, part of which is schematically illustrated in Figure 3a. The amplifier also receives a slowly varying differential input signal, which is schematically represented in Figure 3b. The signal amplitude may only be a few milli-volts. The amplified output signal from the amplifier is schematically represented in Figure 3c and, although the amplifier provides gain to the input signal such that the output amplitude may be several volts the representation of the output has been adjusted so that it looks similar to the input. However it will be noticed that at each clock transition the inputs and outputs of the amplifier 4 are swapped and consequently because the amplifier is a real device it needs to discharge and then recharge any parasitic capacitances therein resulting in a transitional period where the output of the amplifier has to re-establish itself. This gives rise to switching artefacts, generally designated 50 in the signals occurring at the output terminals OP1 and OP2. Furthermore, even if the assumption is made that the amplifier is inherently operating with a DC input and hence has a DC output, and the capacitor is then connected between the terminals OP1 and OP2 in order to sample and store the output voltage, there will still be a perturbation 50 at each clock transition.

Figure 4 schematically shows an embodiment of the present invention in which the amplifier 30 of Figure 2 drives an analog to digital converter 55. The analog to digital converter 55 is responsive to a sample signal which, as shown in Figure 5, when asserted causes the converter 55 to connect its sampling capacitor to the output of the amplifier 30 such that the capacitor is charged to the voltage at the output of the amplifier 30. When the sample signal is de-asserted that connection is broken and the analog to digital converter may then start conversion of the sampled signal. The inventor has then realised that the value sampled and subsequently converted by the analog to digital converter 55 would be compromised if the clock transition occurred within the ADC sample window, or at least within a period preceding the end of that sample window where there would be insufficient time for the sampling capacitor to be recharged to the nominally correct output value.

It should be bourn in mind that it is generally advantageous, from a noise point of view, to seek to limit the input bandwidth of the analog to digital converter and hence the sampling capacitor may be in series connection with a resistor, or a switch having resistance, such that the voltage across the capacitor cannot respond instantaneously to the removal of the switching artefact 50. Thus the inventor has realised that the operation of the circuit could be achieved simply, in a first embodiment, by ensuring that the clock signal does not undergo a transition during the time that the sample signal of the ADC circuit is active. Such an arrangement is shown in Figure 5 where it can be seen that the clock state is inhibited from switching while an ADC "sample" signal is asserted. It can be seen that this results in a modified clock where some of the half cycles of the clock get extended.

The clock signal for the chopper amplifier, which can be regarded as a "chopper clock signal", is generally derived from a periodic (system) clock whose switching instances can be predicted and controlled. Similarly it is common to drive analog to digital converters at a nominally constant sample and convert rate as this often simplifies subsequent processing of the converted values in software. Thus it may be simple enough to modify the circuits driving the chopper clock signal to the chopper amplifier and the sample signal to the analog to digital converter 50 to ensure that ADC sample is not asserted during or near a chopper clock transition or, as shown in Figure 5, that the clock is actually extended prior to assertion of the ADC sample signal such that there is a inhibition period in advance of sampling occurring, such that no clock transitions to the chopper amplifier occur near commencement of or during the sampling of the amplifier output by the ADC.

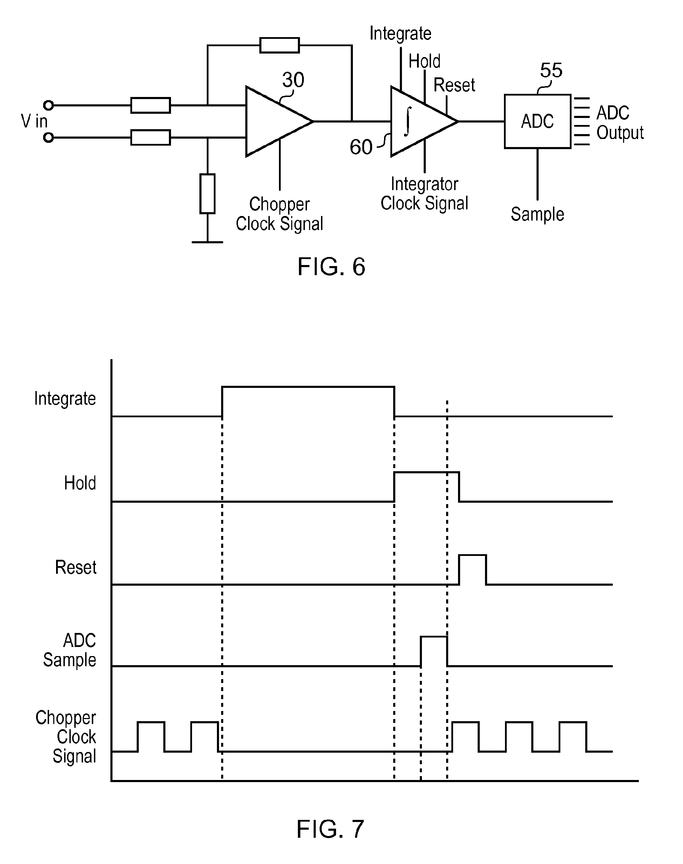

Figure 6 schematically illustrates a further embodiment of the present invention where the output of the chopper amplifier is provided to an integrator 60 whose output may then be provided to the analog to digital converter 55, or indeed to some other signal processing circuit. The integrator 60 need not be described in detail, but as shown advantageously has a reset input in order to force an integrator reset, an integrate input in order to inform the integrator about the period for which it should be integrating and optionally a hold input in order to force the integrator to hold its output steady, although hold may simply be the absence of an integrate signal and thus the integrate and hold instruction may be given by a single line. Indeed, switching between the integrate and hold modes may simply be achieved by disconnecting the input of the integrator 60 from the chopper amplifier 30.

The integrator may be asynchronous, or may be responsive to an integrator clock signal such that a selected one or ones of the integrate, hold and reset signals are only actioned on a specific portion, such as a rising edge or falling edge, of the integrator clock. Thus, the integrator clock may run continuously even though the chopper clock may be selectively inhibited.

Figure 7 is a timing diagram for the circuit shown in Figure 6 showing the status of the integrate, hold, reset, sample and clock signals.

Referring to Figure 7 it can be seen that the clock signal for the chopper amplifier is allowed to run freely until just before the integrate signal is asserted. Once the integrate signal is asserted the clock remains inhibited and consequently the integrator starts to integrate a signal which does not include any switching artefacts. At the end of the integrate period the integrate signal is de-asserted but the hold signal asserted such that the signal at the output of the integrator 60 remains constant. Next the ADC sample signal is asserted such that the ADC 55 samples and holds a copy of the signal at the output of the integrator 60. The ADC sample signal is then de-asserted. Once the ADC sample signal has been reset the chopper clock can be reasserted, the hold signal is de-asserted and the integrator reset signal is briefly asserted. However it should be noted that the integrator reset may be held in the asserted state until just before the integrate signal is itself asserted. Thus, once again, no chopper clock transitions and consequently no chopping artefacts occur during the period that the integrator is integrating or that the sample and hold circuit of the analog to digital converter is sampling the signal to be converted. The timing of the integrate and/or sample signal need not be synchronised with the chopper clock signal.

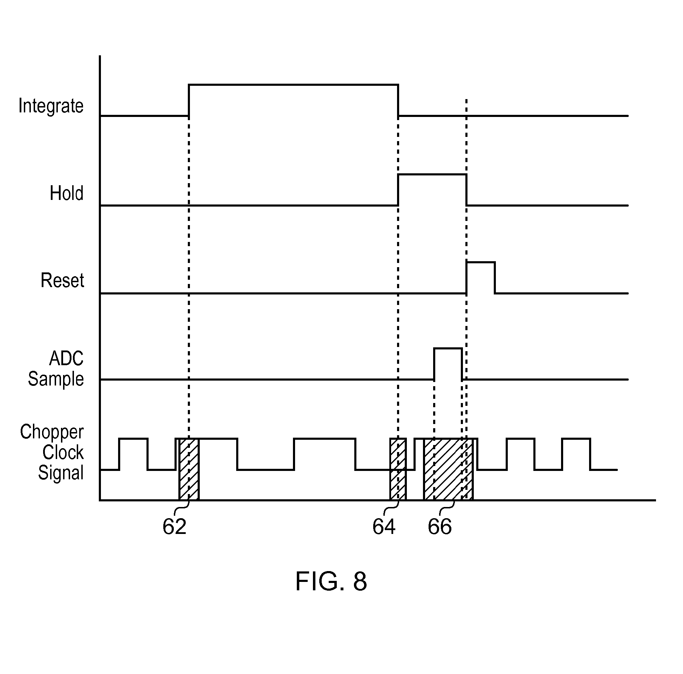

Figure 8 shows a further modification, which can be used with the circuit shown in Figure 6, but where the clock signal for the chopping amplifier is still active during the integrate period, but is timed or otherwise modified such that no transition of the chopper clock signal coincides with the ADC sampling period. The timing of the clock signal may be synchronised to the start of the ADC sampling sequence such that each future ADC sample has the same effective start point that does not coincide with the clock signal transition. In a preferred embodiment a clock inhibition circuit, for example as shown in Figure 9 may be acted on by a controller that schedules the integrate, hold and reset signals so as to use the inhibition circuit to inhibit clock transitions during the inhibition periods 62, 64 and 66 which coincide with changes of the integrate, hold or reset signals. As shown in Figure 8 the inhibition periods do not need to be of the same duration as each other. Three inhibition periods have been shown in this example, but the system designer has a choice over this. Thus, for example a clock signal to the chopper amplifier is allowed to occur in the gap between inhibition period 64 and inhibition period 66. This is potentially advantageous compared to providing a longer inhibition period encompassing periods 64 and 66 because, in general, chopper amplifiers benefit from being clocked.

In the embodiment illustrated in Figure 6 any perturbation caused by the switching artefacts is consistent throughout the sampling sequence and integration period and as such has potential to be calibrated out. This can be achieved in software by applying a correction to the value output by the analog to digital converter. It is also possible that a correction might be done in hardware by, for example, performing a controlled charge injection to the integrator at each clock transition, wherein the charge injection is sized so as to substantially compensate for the switching artefact. The charge injection may, for example, be achieved by switching on a programmable current source or sink for a predetermined period of time thereby removing the correction overhead from the software domain to the hardware domain. The choice of whether the correction is done in hardware or software can be made by the system designer or integrator with knowledge of other operational parameters.

The present invention is particularly beneficial in high temperature environments where the leakage current from operational amplifiers tends to increase and offset voltage and drift may have a greater impact on analog to digital converter performance. The invention also provides significant benefits in circuits which incorporate high (long) integration periods since the problems associated with the integration of the spurious switching signals are mitigated.

Preliminary tests suggest that the invention provides an order of magnitude decrease in noise levels at about the 1 LSB level and almost complete removal of noise from the artefact at the 2 LSB level. The results of testing are summarised in table 1.

**Table 1**

| | **Samples using unsynchronised clocks (based on 141k samples)** | **Samples with synchronization(based on 70k samples)** |
|---|---|---|
| **Noise > ± 1 bit** | **0.7% of samples** | **0.07% of samples** |
| **Noise > ± 2 bit** | **0.35% of samples** | **0.00% of samples** |

Figure 9 shows a simple circuit which may be used to inhibit clock transitions of the chopper clock to the chopper amplifier whilst the sample signal is asserted. This circuit is particularly suited where the chopper clock runs at a significantly lower frequency than a system clock and hence a divide by 2 can be incorporated. In the arrangement shown in Figure 9 a clock signal, labelled clock 2 because it has a clock frequency twice the chopper clock frequency is provided to a first input of an AND gate 70. An inhibit signal, "INHIBIT", which might be the sample signal is provided to an inverter 72 whose output is connected to a second input of the AND gate 70. Thus, the output of the AND gate mirrors the signal clock 2 whilst INHIBIT is "0" and is forced to "0" when INHIBIT is "1". This arrangement can be used to force the clock signal to zero whenever INHIBIT is asserted. However, in some arrangements such as that shown in Figure 5 it is desired to extend the clock in its current state, whether that be a "0" or an "1". In this instance the output of the AND gate is provided to a clock input of a D-type gate whose inverting output Q-bar is connected to the data input D of the D-type gate. This configuration is well known to the person skilled in the art and gives a divide by 2 action, but importantly ensures that the clock signal which is taken from the "Q" output of the D-type gate holds its current state whenever the INHIBIT signal is asserted.

It is thus possible to provide an enhanced signal processing circuit which reduces the effect of switching artefacts from a chopper amplifier (which term includes a chopper stabilised amplifier).

## Claims

1. A signal processing circuit comprising a chopper amplifier (30) in combination with a circuit or device (55) having an acquisition period, and **characterised in that** a clock controlling the chopper amplifier (30) is modified or suspended such that a predetermined or known number of clock transitions occur during the acquisition period.

2. A signal processing circuit as claimed in claim 1, in which the circuit or device having an acquisition period comprises an analog to digital converter (55) in combination with or including a sample and hold circuit or a track and hold circuit, and wherein the clock controlling the chopper amplifier is controlled such that no clock transitions occur in a period when the analog to digital converter is sampling an output of the chopper amplifier with a sample and hold circuit, or transitioning to the hold stage of a track and hold circuit.

3. A signal processing circuit as claimed in claim 1 or 2 further comprising a clock modification circuit for suspending the clock during the acquisition period.

4. A signal processing circuit as claimed in any of the preceding claims, further comprising an integrator (60) arranged to receive the output of the chopping amplifier (30) and to integrate it over an integration period.

5. A signal processing circuit as claimed in claim 4, in which the integrator (60) is controllable to switch to a "hold" mode, and the clock controlling the chopper amplifier is inhibited from making a transition during the "hold" mode.

6. A signal processing circuit as claimed in claim 4 or 5, in which the clock controlling the chopper amplifier (30) is inhibited during an integration period of the integrator.

7. A signal processing circuit as claimed in claim 4 or 5, in which the clock controlling the chopper amplifier (30) is allowed to run during the integration period, said integration period forming part of the acquisition period, with the number of transitions being predetermined or counted such that a correction to the integrator output can be estimated based on the clock transitions.

8. A signal processing circuit as claimed in claim 7, in which the correction is made in hardware by injection of a correction signal to the integrator and the analog to digital converter, or in software in processing of the output of the analog to digital converter.

9. A signal processing circuit as claimed in any of the preceding claims, further comprising a clock modification circuit for suspending the clock to the chopper amplifier for at least one inhibition period.

10. A signal processing circuit as claimed in claim 9, wherein the at least one inhibition period starts in advance of and ends after a transition starting or ending the acquisition period.

11. A signal processing circuit as claimed in claim 4 when dependent on claim 2, in which at least one clock transition occurs between the end of an integrate period and the sampling of the integrated signal by the analog to digital converter.

12. A signal processor circuit as claimed in any of the preceding claims in which the predetermined number of clock transitions is zero.

13. A method of processing a signal, the method comprising amplifying the signal using a chopper amplifier (30), and acquiring an output from the chopper amplifier during an acquisition period, wherein a clock signal controlling the chopper amplifier is modified or suspended so as to make a predetermined number of transitions during the acquisition period.

14. A method as claimed in claim 13, in which the signal is acquired by an analog to digital converter co-operating with a sample and hold circuit, and the sample and hold circuit has an acquisition period in which it samples the output from the chopper amplifier, and the predetermined number of clock transitions is zero.

15. A method as claimed in claim 13 or 14, further comprising the step of integrating the signal during an integration period, and wherein the integration period forms part of the acquisition period.

16. A method as claimed in claim 13 or 14 or 15, further comprising integrating the signal during an integration period, and wherein the integrator can be placed in a "hold" mode and the time for which the integrator is in the hold mode forms part or all of the acquisition period.
